Europäisches Patentamt

European Patent Office

Office européen des brevets

(11) Numéro de publication : **0 041 882**
**B1**

# FASCICULE DE BREVET EUROPÉEN

(45) Date de publication du fascicule du brevet :
**11.04.84**

(51) Int. Cl.³ : **H 03 L   7/22**

(21) Numéro de dépôt : **81400821.5**

(22) Date de dépôt : **22.05.81**

(54) **Dispositif de prépositionnement de fréquence pour synthétiseur indirect de fréquence, et synthétiseur comportant un tel dispositif.**

(30) Priorité : **03.06.80 FR 8012279**

(43) Date de publication de la demande :
**16.12.81 Bulletin 81/50**

(45) Mention de la délivrance du brevet :
**11.04.84 Bulletin 84/15**

(84) Etats contractants désignés :
**BE CH DE GB LI NL SE**

(56) Documents cités :
**EP-A- 0 025 876**
**DE-A- 2 814 577**
**FR-A- 2 328 324**
**GB-A- 2 015 277**
**IEEE   TRANSACTIONS   ON   CONSUMER   ELEC-**
**TRONICS, vol. CE-26, no. 1, février 1980 NEW YORK**
**(US) K. TSUKAMOTO et al. : « A new tuning system**
**with non-volatile analog memory » pages 20-26**

(73) Titulaire : **THOMSON-CSF**
**173, Boulevard Haussmann**
**F-75379 Paris Cedex 08 (FR)**

(72) Inventeur : **Charavit, Jean-Claude**
**THOMSON-CSF SCPI 173, bld Haussmann**
**F-75360 Paris Cedex 08 (FR)**
Inventeur : **Vandroux, Michel**
**THOMSON-CSF SCPI 173, bld Haussmann**
**F-75360 Paris Cedex 08 (FR)**

(74) Mandataire : **Benoit, Monique et al**
**THOMSON-CSF SCPI 173, Bld Haussmann**
**F-75379 Paris Cedex 08 (FR)**

Jouve, 18, rue St-Denis, 75001 Paris, France

Dispositif de prépositionnement de fréquence pour synthétiseur indirect de fréquence, et synthétiseur comportant un tel dispositif

L'invention est relative à un dispositif de prépositionnement de fréquence pour synthétiseur indirect de fréquence. Elle concerne plus particulièrement un synthétiseur indirect de fréquence à boucles de phase commutables.

Ce dispositif permet la réalisation d'un synthétiseur de fréquence indirect utilisant une ou plusieurs boucles d'asservissement de phase. L'invention permet d'améliorer la rapidité de stabilisation — ou temps d'acquisition — de la fréquence de sortie du synthétiseur.

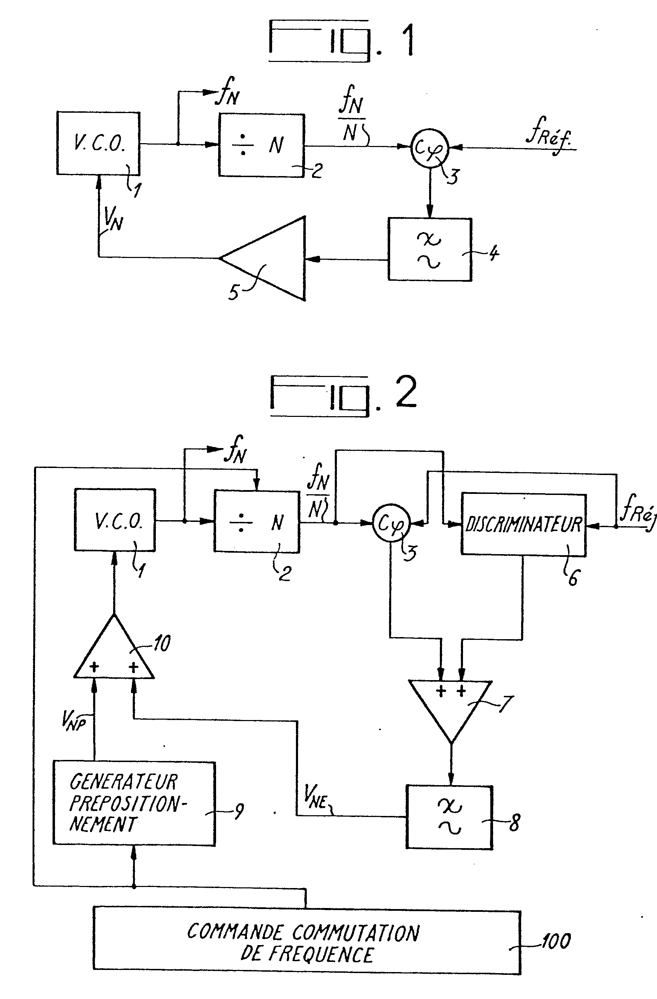

On va rappeler très succinctement, dans ce qui suit, quelques schémas de réalisation d'un synthétiseur. Un synthétiseur est un dispositif qui permet de générer un signal sinusoïdal dont la fréquence est programmée par une commande numérique. La figure 1 représente le schéma simplifié d'un synthétiseur indirect de fréquence à boucle de phase, basé sur le principe de l'asservissement d'un sous-multiple de la fréquence d'un oscillateur commandé par une tension ou V.C.O. (Voltage Controlled Oscillator) sur une fréquence de référence stable, de bonne pureté spectrale. Ce synthétiseur est constitué d'un oscillateur V.C.O. 1 fournissant une fréquence de sortie $f_N$ dépendant de la tension de commande $V_N$ qui lui est appliquée. La sortie de cet oscillateur 1 est reliée à un circuit 2 diviseur de fréquence par N — N étant entier — qui délivre un signal de sortie à la fréquence $f_N/N$ appliqué à un comparateur de phase 3, auquel on applique également une fréquence $f_{ref}$ dite de référence, et qui délivre un signal dont la composante continue est proportionnelle à la différence de phase existant entre les deux signaux qui lui sont appliqués. A la sortie de ce comparateur est connecté un filtre passe-bas 4 dont le but est d'éliminer les composantes hautes du spectre du signal de sortie du comparateur de phase. Ce filtrage évite que la tension de commande $V_N$ appliquée à l'oscillateur 1 produise une modulation parasite de la fréquence de sortie $f_N$. Enfin, un amplificateur 5 est placé entre le filtre 4 et l'oscillateur 1 de façon à donner le gain de bande nécessaire au fonctionnement de celle-ci.

Comme le temps de commutation du synthétiseur est inversement proportionnel à la largeur de bande de la boucle, on cherche à diminuer ce temps de commutation en augmentant la largeur de la bande par les différentes méthodes qui suivent. Une première méthode consiste à augmenter la fréquence de référence. Malheureusement deux limitations technologiques se présentent : tout d'abord, plus la fréquence de référence est élevée plus le diviseur programmable doit fonctionner à des fréquences élevées, ensuite, dans le cas d'un synthétiseur à une seule boucle, cette fréquence de référence doit être inférieure au pas de saut de fréquence du synthétiseur.

Une seconde méthode consiste à abaisser la fréquence $f_N$ à diviser, soit par une transposition de fréquence, soit par l'utilisation de boucles multiples, le signal de sortie d'une boucle servant de fréquence de transposition dans une autre boucle.

Enfin, une troisième méthode consiste à utiliser un prépositionnement de fréquence, comme le montre la figure 2. Quand on effectue la programmation du rang de division N, on effectue simultanément une programmation d'une tension de prépositionnement $V_{NP}$ qui est ajoutée à la tension de commande fournie par l'asservissement. Cette solution minimise l'écart de fréquence que la boucle d'asservissement doit rattraper après une commutation de fréquence. Cependant, ce prépositionnement ne peut être précis à cause des non-linéarités et des dispersions de la caractéristique tension-fréquence de l'oscillateur VCO, en fonction du temps, ainsi qu'en fonction de la température.

Pour remédier à ces inconvénients, l'invention se propose d'améliorer le dispositif de prépositionnement de fréquence.

Suivant une caractéristique de l'invention, le dispositif de prépositionnement de fréquence pour synthétiseur indirect à boucles de phase commutables asservissant sur une fréquence de référence stable un sous-multiple de la fréquence d'un oscillateur commandé par une tension $V_N$ et comprenant au moins un générateur programmable de tension de prépositionnement, pour chaque fréquence commutée la tension de prépositionnement $V_{NP}$ programmée pour chaque boucle étant ajoutée à la tension d'erreur $V_{NE}$ établie dans la même boucle pour donner la tension de commande $V_N$ de l'oscillateur, est tel qu'il comporte un dispositif de mémorisation des valeurs de la tension de commande $V_N$ à chaque passage sur chaque fréquence $f_N$, ces valeurs étant utilisées aux passages suivants sur la même fréquence pour commander le générateur de prépositionnement et le rendre ainsi auto-adaptatif.

D'autres caractéristiques et avantages de l'invention apparaîtront dans la description illustrée par les figures 1 à 9 qui, outre la figure 1 déjà décrite, représentent :

la figure 2, un synthétiseur indirect de fréquence comportant un dispositif de prépositionnement de fréquence selon l'art antérieur ;

la figure 3, un schéma de principe d'un synthétiseur indirect de fréquence, comportant un dispositif de prépositionnement de fréquence selon l'invention ;

les figures 4 à 8, des variantes de réalisation du schéma de principe d'un synthétiseur de fréquence à une seule boucle commutable selon l'invention ;

la figure 9, un schéma de réalisation d'un synthétiseur de fréquence à plusieurs boucles commutables selon l'invention.

Sur ces différentes figures, les éléments identiques et remplissant les mêmes fonctions portent les mêmes références.

**0 041 882**

Le synthétiseur indirect de fréquence, représenté sur la figure 2, comporte un dispositif de prépositionnement de fréquence selon l'art antérieur. Ce synthétiseur est constitué comme celui de la figure 1 par un oscillateur VCO 1, un circuit diviseur 2 de la fréquence de sortie $f_N$ de l'oscillateur 1 commandé par un dispositif de commutation de fréquence 100, un comparateur de phase 3 auquel on a ajouté un discriminateur de fréquence 6 placé en parallèle sur le comparateur 3. Lors d'un saut de fréquence de grande amplitude approchant ou dépassant la plage d'accrochage de la boucle de phase, on réalise l'accrochage en utilisant un discriminateur de fréquence qui fournit une tension proportionnelle à la différence des fréquences qui lui sont appliquées. Lorsque les fréquences comparées sont identiques, le discriminateur ne fournit pas de tension de commande, celle-ci est alors fournie par le comparateur de phase qui a pris le relais. Un amplificateur sommateur 7 reçoit les signaux issus du comparateur 3 et du discriminateur 6 et fournit un signal qui est filtré par un filtre passe-bas 8 qui joue le même rôle que le filtre passe-bas 4 décrit en figure 1.

Lorsque l'on assimile la caractéristique tension-fréquence de l'oscillateur VCO 1 à une droite de la forme :

$$f_N = f_o + k \cdot V$$

on constate la correspondance qui existe entre la programmation du rang de division N et la tension de commande correspondante $V_N$ de l'oscillateur :

$$f_N = N \cdot f_{ref} = f_o + kV_N$$

d'où

$$V_N = - f_o/k + N (f_{ref}/k) = a + b \cdot N$$

on peut donc effectuer simultanément la programmation du rang de division N et celle d'une tension de prépositionnement $V_N$ qui est ajoutée à la tension de commande fournie par l'asservissement.

Ainsi pour minimiser l'écart de fréquence que la boucle d'asservissement doit rattraper après une commutation de fréquence, on ajoute à la boucle un générateur de tension de prépositionnement 9 de façon à positionner l'oscillateur 1 le plus près possible de la fréquence à fournir lors de la commutation de fréquence. La commande de commutation de fréquence 100 agit à la fois sur le circuit diviseur 2 et sur le générateur de tension 9. Ce dernier délivre une tension $V_{NP}$ qui combinée, à l'aide d'un circuit sommateur 10, à la tension $V_{NE}$ délivrée par le filtre 8 constitue la tension de commande $V_N$ de l'oscillateur 1. Il serait très intéressant d'effectuer un positionnement exact sur la fréquence $f_N$ à fournir pour que la boucle d'asservissement n'ait plus qu'à contrôler la phase de l'oscillateur 1 VCO, ce qui augmenterait la rapidité de stabilisation de la fréquence de sortie du synthétiseur. Toutefois, comme cela a été dit plus haut, des limitations technologiques empêchent cette grande précision dans le positionnement et l'invention a pour but d'y remédier.

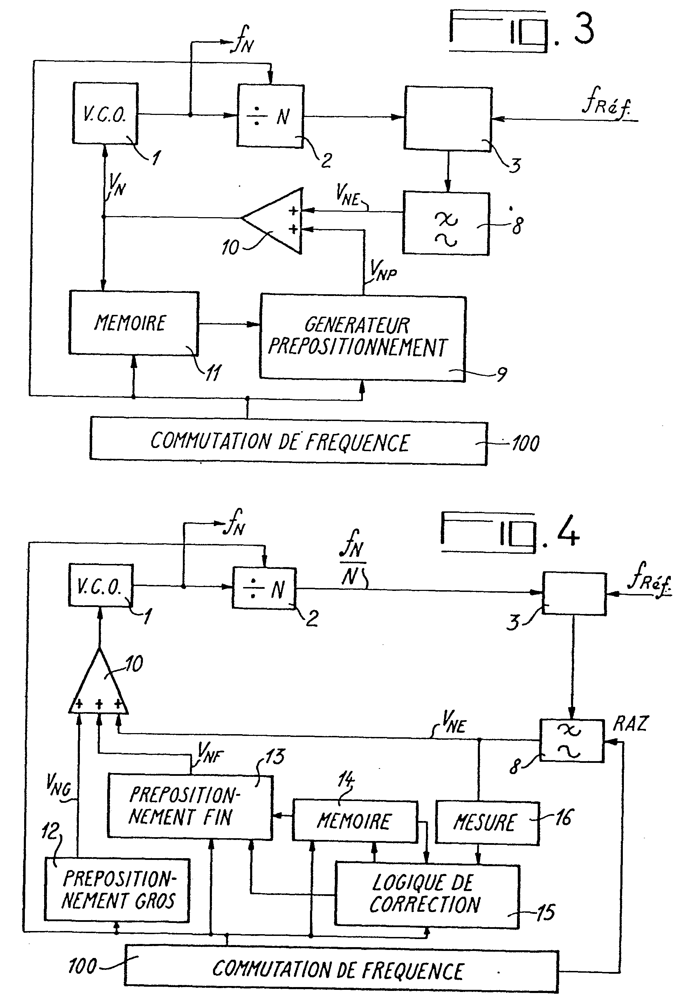

La figure 3 représente un schéma de principe d'un synthétiseur indirect de fréquence, comportant un dispositif de prépositionnement selon l'invention. Il est constitué par un oscillateur VCO 1 délivrant un signal de fréquence $f_N$, qui est divisée par N par un circuit diviseur 2 dont le signal de sortie est comparé à un signal de référence dans un circuit de comparaison de phase et de fréquence 3. Ce dernier délivre une tension $V_{NE}$ dite d'erreur, filtrée par le filtre passe-bas 8. L'invention consistant à faire le relevé continuel de la caractéristique tension-fréquence de l'oscillateur VCO afin de commander le générateur de tension de prépositionnement à la valeur la plus proche possible de la valeur exacte, la boucle d'asservissement comporte un dispositif de mémorisation 11 des tensions de commande $V_N$ de l'oscillateur 1, relié au générateur de tension de prépositionnement 9. Le circuit diviseur 2, le dispositif de mémoire 11 et le générateur 9 sont reliés à la commande de commutation de fréquence 100. Comme dans la figure 2, la tension de prépositionnement $V_{NP}$ délivrée par le générateur 9 est ajoutée à la tension d'erreur $V_{NE}$ dans un circuit sommateur 10, qui délivre en sortie la tension de commande $V_N$ de l'oscillateur VCO 1.

Le fonctionnement de ce dispositif est le suivant : à chaque commutation de fréquence, le dispositif mémoire 11 délivre au générateur 9 la valeur de la tension $V_N$ mémorisée lors des passages précédents sur la même fréquence $f_N$ et la valeur du rang N de division du circuit 2 est changée. Cette tension mémorisée devient la tension $V_{NP}$ de prépositionnement et est ajoutée à la tension d'erreur $V_{NE}$ obtenue dans la boucle de phase, celle-ci ayant atteint son équilibre. La somme de ces deux tensions $V_{NE}$ et $V_{NP}$ donne la nouvelle tension $V_N$ de commande de l'oscillateur VCO 1, qui est en même temps mémorisée dans le dispositif 11.

A chaque passage sur chacune des valeurs $f_N$, la nouvelle valeur de la tension de commande $V_N$ de l'oscillateur VCO est mémorisée pour compenser les dérives du matériel et pour améliorer éventuellement la précision des mesures par filtrage des mesures successives. Ces mesures peuvent s'effectuer :
— soit pendant le fonctionnement du synthétiseur en régime établi au passage sur chaque fréquence $f_N$ :
si le temps pendant lequel la fréquence n'est pas modifiée est suffisant il est possible d'effectuer un filtrage de la tension de commande $V_N$ du VCO 1 afin d'éliminer les fluctuations introduites par l'asservissement. Sinon on peut effectuer un filtrage à partir de plusieurs échantillons mesurés à des passages successifs sur la même fréquence. Ce filtrage peut être utilisé aussi pour constater des dérives

3

du matériel ou effectuer des corrections par interpolation sur les tensions de prépositionnement $V_N$ qui n'ont pas été rafraîchies depuis trop longtemps ou pour effectuer le contrôle dynamique du bon fonctionnement du synthétiseur ;

— soit pendant les durées où le synthétiseur n'a pas à fournir de signal utile, par exemple dans un système de transmission pendant les temps morts de transmission ;

durant ces temps morts le synthétiseur peut explorer cycliquement les diverses fréquences possibles, il faut alors que la fréquence des temps morts soit suffisamment grande devant la vitesse des dérives du synthétiseur.

Le dispositif de prépositionnement suivant l'invention est auto-adaptatif, puisqu'à chaque passage sur la fréquence $f_N$, le générateur de tension de prépositionnement délivre une tension $V_N$ la plus proche possible de la valeur à fournir pour commander l'oscillateur. Ainsi, la vitesse de positionnement du synthétiseur à la valeur de fréquence désirée est accrue sans que la boucle d'asservissement de phase soit modifiée. Donc la pureté spectrale du synthétiseur, obtenue grâce à la fréquence de référence $f_{ref}$ stable, n'est pas non plus modifiée.

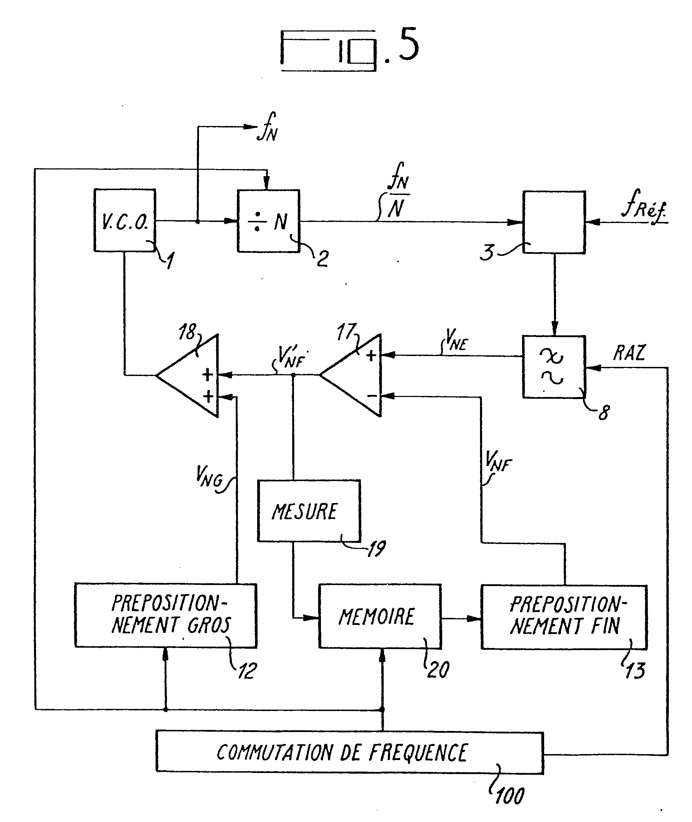

La figure 4 représente une première variante de schéma de principe d'un dispositif de prépositionnement selon l'invention. La tension de prépositionnement est décomposée en deux composantes $V_{NG}$ et $V_{NF}$. La première composante $V_{NG}$ est fixe et sert de prépositionnement, dit « grossier », agissant de la même façon que la tension de prépositionnement de l'art antérieur. La seconde composante $V_{NF}$ est variable et sert de prépositionnement, dit « fin », qui suit les fluctuations et dérives de la tension de commande $V_N$ de l'oscillateur VCO. Les corrections de la composante $V_{NF}$ sont fonction de la valeur de la tension de commande $V_N$ donc de la tension d'erreur $V_{NE}$ résiduelle de prépositionnement filtrée fournie par le comparateur de phase.

Le dispositif comporte les mêmes circuits 1, 2, 3, 8 et 10 que ceux du dispositif de la figure 3, auxquels sont ajoutés un générateur de prépositionnement gros 12, un générateur de prépositionnement fin 13, un circuit logique de correction 15, un circuit de mémorisation de la tension de prépositionnement fin $V_{NF}$ 14 — tous quatre reliés au circuit de commande de commutation de fréquence 100 ainsi que le circuit diviseur 2 par N — et un circuit de mesure 16 de la tension d'erreur résiduelle $V_{NE}$. A chaque commutation de fréquence, le circuit de commande 100 agit sur le circuit diviseur N dont la valeur entière de N est modifiée et sur le générateur de prépositionnement gros 12 qui fournit une valeur de $V_{NG}$ programmée initialement. Ce même circuit 100 agit en même temps sur le circuit mémoire 14 qui fournit alors au circuit de logique de correction 15 la valeur de la tension de prépositionnement fin $V_{NF}$ mémorisée au passage précédent sur la même fréquence. Quand l'équilibre est établi dans la boucle de phase, la valeur de la tension d'erreur résiduelle $V_{NE}$, produite par le circuit 3 et filtrée par le filtre passe-bas 8 est mesurée dans le circuit 16 et ajoutée, dans le circuit de logique de correction 15, à la tension $V_{NF}$. Ce circuit 15 effectue une correction de la tension de prépositionnement fin $V_{NF}$ tendant à rendre nulle la tension d'erreur $V_{NE}$, et la remplace par une nouvelle valeur $V'_{NF}$. Le circuit sommateur 10 ajoute ensuite les trois tensions $V_{NG}$, $V'_{NF}$ et $V_{NE}$ pour donner la tension de commande $V_N$ à l'oscillateur VCO 1 qui fournit bien alors la fréquence $f_N$ désirée.

La nouvelle valeur $V'_{NF}$ est ensuite mémorisée dans le circuit mémoire 14, pour être utilisée au prochain passage pour la même fréquence $f_N$ et le filtre 8 reçoit du circuit logique 15 une commande de remise à zéro de façon qu'à la commutation suivante sur une autre fréquence, la tension $V_{NE}$ soit nulle avant l'établissement de l'équilibre dans la boucle de phase.

De façon pratique, la tension d'erreur $V_{NE}$ peut être mesurée par un dispositif à échantillonnage et conversion analogique numérique par exemple. Le pas de quantification peut être de même ordre de grandeur que l'amplitude crête des fluctuations de la tension d'erreur. Lorsque la fréquence commutable passe de la valeur $f_N$ à la valeur $f'_N$, la logique de correction utilise la valeur mesurée de la tension d'erreur $V_{NE}$ pour effectuer une correction de la tension de prépositionnement fin $V_{NF}$ et la remplacer par une nouvelle valeur $V'_{NF}$. Si on admet qu'en régime établi, la tension de commande $V_N$ de l'oscillateur VCO est égale à la somme des tensions de prépositionnement gros et fin et de la tension d'erreur à des coefficients multiplicatifs $\alpha$, $\beta$ et $\gamma$ près :

$$V_N = \alpha \cdot V_{NG} + \beta \cdot V_{NF} + \gamma \cdot V_{NE},$$

la correction qui tend à rendre la tension d'erreur nulle fait que :

$$\beta \cdot V_{N'F} = \beta \cdot V_{NF} + \gamma V_{NE}$$

soit

$$V_{N'F} = V_{NF} + \gamma/\beta \cdot V_{NE}$$

Cette dernière relation indique que si le générateur de tension de prépositionnement fin est réalisé à partir d'un convertisseur numérique analogique CNA, le pas de quantification est dans le rapport $\gamma/\beta$ par rapport au pas du CAN de mesure de tension d'erreur $V_{NE}$. Le circuit de mémorisation 14 des valeurs numériques des tensions $V_{NF}$ pour les diverses fréquences commutables du synthétiseur est une mémoire vive, adressée par la commande de fréquence 100.

Le générateur de prépositionnement gros 12 peut être constitué par un convertisseur numérique

0 041 882

analogique commandé soit directement par la commande de fréquence 100, soit par l'intermédiaire d'une mémoire morte servant à un transcodage et à une éventuelle compensation des non-linéarités de la caractéristique tension-fréquence du VCO.

Pour introduire les valeurs initiales des tensions de prépositionnement fin dans le circuit 13, il faut effectuer au moins un passage sur chaque fréquence du synthétiseur lors de sa mise en route. Afin de faciliter l'initialisation, le filtre passe-bas 8 peut comporter une bande passante commutable, plus large lors du premier passage sur chaque fréquence du synthétiseur et moins large ensuite.

Une seconde variante du schéma de principe d'un dispositif de prépositionnement selon l'invention est représenté sur la figure 5. Il n'y a plus de circuit de logique de correction qui corrige la tension de prépositionnement fin $V_{NF}$ en fonction de la valeur de la tension d'erreur résiduelle $V_{NE}$.

Le circuit de commande de commutation de fréquence 100 agit, comme précédemment, sur le circuit diviseur 2, le générateur de prépositionnement gros 12 et un circuit mémoire 20 qui, à chaque commutation de fréquence, mémorise la valeur de la tension $V'_{NF}$ résultant de la somme de la tension de prépositionnement fin $V_{NF}$ et de la tension d'erreur $V_{NE}$. Cette tension $V_{NF}$ est mesurée par le circuit 19. Ainsi, à chaque commutation de fréquence la logique d'enchaînement réalise les fonctions suivantes :

— le filtre 8 remis à zéro par la commande 100 de façon à annuler $V_{NE}$ ;

— la commande 100 met la mémoire 20 en lecture et sélection pour fournir au générateur 13 la valeur de tension de prépositionnement fin $V_{NF}$ ;

— attente de stabilisation donnant la valeur de la tension d'erreur $V_{NE}$ qui est ajoutée à $V_{NF}$ dans le circuit sommateur 17 ;

— mise de la mémoire 20 en écriture pour mémoriser la valeur $V'_{NF} = V_{NF} + V_{NE}$ et blocage de la mémoire.

Parallèlement, la commande de commutation 100 a agi sur le générateur 12 de tension de prépositionnement gros $V_{NG}$ et sur le circuit diviseur programmable 2. A l'instant de la mise en écriture de la mémoire 20, le synthétiseur délivre la fréquence demandée.

La mémorisation du dispositif de prépositionnement fin peut être réalisée de plusieurs façons, dont deux vont être exposées dans ce qui suit.

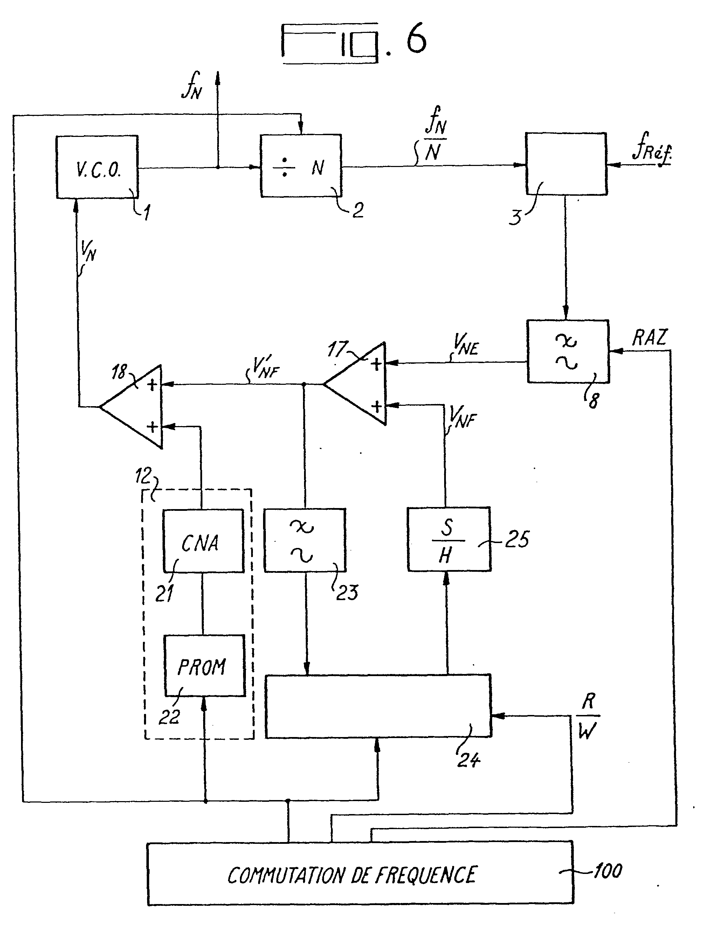

La figure 6 montre un type de mémorisation fine analogique. Les éléments portant les mêmes références que dans la figure précédente ne seront pas décrits. Comme cela a été déjà dit, le générateur de prépositionnement gros 12 peut être constitué d'un convertisseur numérique analogique 21 commandé par la commande de commutation de fréquence 100 par l'intermédiaire d'une mémoire morte 22, du type PROM par exemple. La tension de prépositionnement fin $V'_{NF}$ en sortie du circuit sommateur 17 est filtrée à travers le filtre passe-bas 23, puis est mise dans le circuit de mémorisation 24 qui est une mémoire vive de type analogique à accès aléatoire, commandée directement par la commande de commutation de fréquence 100. Entre le circuit mémoire 24 et une des entrées du circuit sommateur 17 est placé un circuit échantillonneur bloqueur 25 qui joue le rôle d'interface.

Le processus de fonctionnement du synthétiseur, à chaque commutation de fréquence $f_N$ est le suivant :

— remise à zéro du filtre 8 par commande 100 ;

— mise du circuit mémoire 24 en lecture et sélection ;

— déblocage du circuit échantillonneur bloqueur 25 qui délivre, à l'entrée du circuit sommateur 17, la valeur de la tension $V_{NF}$ mémorisée lors du précédent passage sur cette même fréquence $f_N$ ;

— blocage du circuit 25 ;

— déblocage du filtre 8 ;

— attente de stabilisation de la boucle de phase ;

— mise du circuit mémoire 24 en écriture, à cet instant, le synthétiseur délivre la bonne fréquence ;

— blocage du circuit mémoire 24.

Parallèlement la commande fréquence 100 avait agi sur le circuit mémoire 22 et le convertisseur numérique analogique 21, ainsi que sur le circuit diviseur 2 programmable.

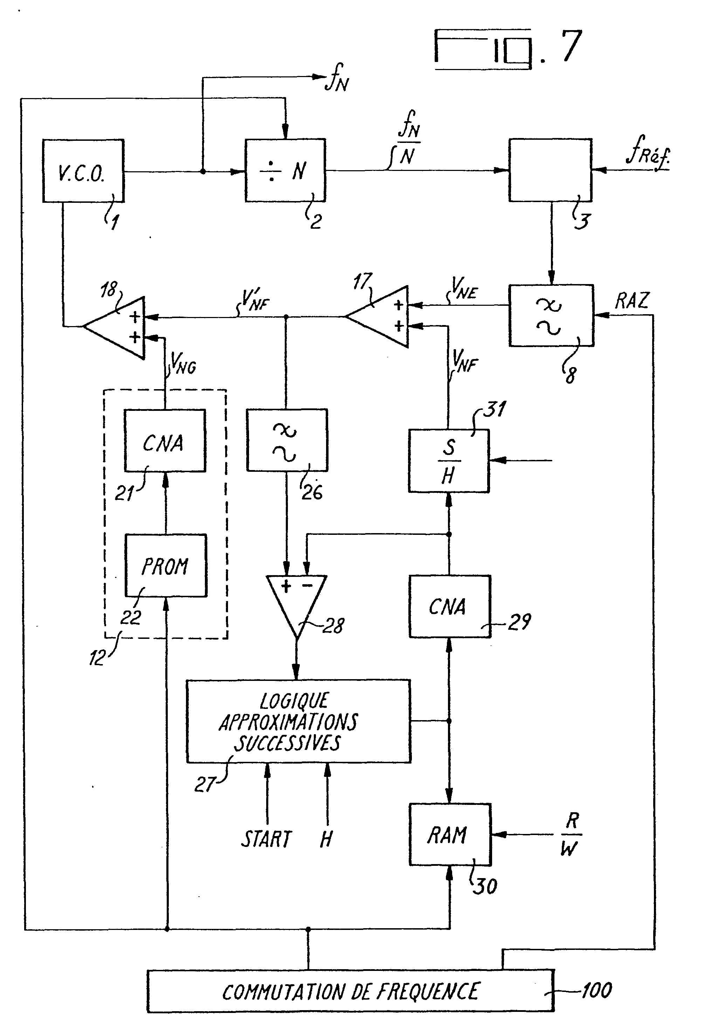

La figure 7 montre un type de mémorisation fine digitale. Comme précédemment, les éléments portant les mêmes numéros que dans les figures précédentes ont la même fonction et ne seront pas décrits une nouvelle fois. La différence qui existe entre cette figure et la précédente réside dans la réalisation du générateur de tension de prépositionnement fin, les dispositifs de mesure et de restitution de la tension d'erreur étant confondus en un dispositif qui réalise les deux fonctions l'une après l'autre.

Dans cette variante du synthétiseur représenté par la figure 7, le fonctionnement de la logique d'enchaînement des opérations de mesure et de restitution de la tension d'erreur est le suivant, à chaque commutation de fréquence :

— le filtre passe-bas 8 est mis à zéro par la commande ;

— le dispositif mémoire 30 est mis en lecture et sélection pour donner la tension $V_{NF}$ mémorisée au passage précédent sur la même fréquence ;

— déblocage de l'échantillonneur-bloqueur 31 ;

— attente de stabilisation du convertisseur 29 ;

— blocage de l'échantillonneur 31 ;

— déblocage du filtre 8 ;

— attente de stabilisation de la boucle de phase (à cet instant le synthétiseur délivre la bonne

5

fréquence $f_N$) ;

— mesure de la tension $V'_{NF}$ par le filtre passe-bas 26 ;

— initialisation de la logique d'approximations sucessives ;

— la logique d'approximations successives délivre une tension V numérique, qui est convertie analogiquement dans le convertisseur 29 pour être comparée à la tension analogique $V'_{NF}$ dans le circuit 28 ; quand ces deux tensions analogiques V et $V'_{NF}$ sont égales, la logique s'arrête et la tension numérique alors obtenue est mémorisée dans la mémoire à accès aléatoire RAM 30 (Random Access Memory) ;

— blocage de la mémoire 30.

Parallèlement la commande de commutation de fréquence a agi sur le circuit mémoire 22 qui, par l'intermédiaire du convertisseur numérique analogique 21 délivre la tension de prépositionnement gros $V_{NG}$, ainsi que le circuit 2 diviseur par N.

Un tel dispositif permet de compenser les dérives du système pourvu qu'elles soient lentes devant la fréquence d'utilisation de chaque fréquence disponible dans le synthétiseur.

Suivant un exemple de réalisation, un synthétiseur tel que celui décrit figure précédente comporte en plus de la commande de commutation de fréquence un système d'interface avec un calculateur ou microprocesseur et un circuit de logique d'enchaînement. Ainsi, un tel synthétiseur peut avoir quatre modes de fonctionnement :

— un mode d'initialisation dans lequel un calculateur peut intervenir pour déterminer les premières tensions de prépositionnement fixe ;

— mode normal, dans lequel le synthétiseur est alors piloté par la commande de commutation de fréquence ;

— mode test, pendant lequel un calculateur prélève les valeurs de la tension de prépositionnement fin de la mémoire RAM afin de réaliser des tests de vraisemblance et de continuité. Connaissant la caractéristique tension-fréquence de l'oscillateur VCO donnée par le constructeur, il est alors possible de vérifier que le synthétiseur délivre bien une semblable caractéristique restant dans les limites des variations annoncées par le constructeur ;

— mode conservatif, le synthétiseur n'étant pas utilisé le système parcourt l'ensemble des fréquences utiles afin de mettre la RAM à jour des diverses dérives.

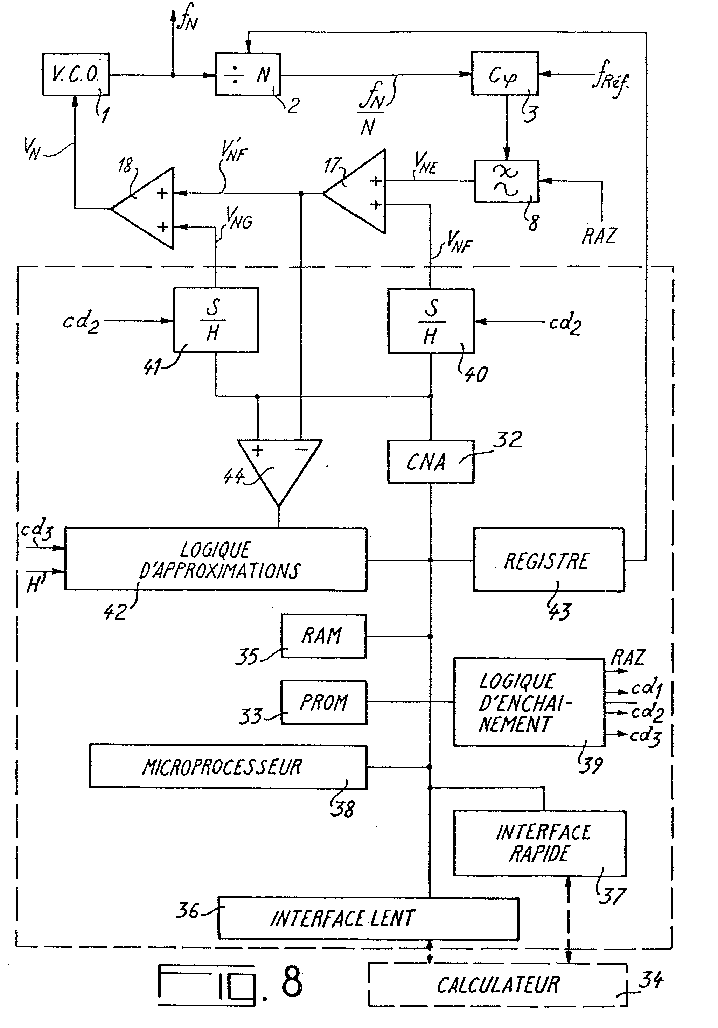

La figure 8 montre une réalisation d'un synthétiseur selon l'invention, dont une grande partie peut être intégrée en circuit LSI (Large Scale Integration). Un seul convertisseur numérique analogique 32 est nécessaire pour les deux prépositionnements gros et fin. Un dispositif mémoire 33 du type PROM contient :

— la loi de prépositionnement gros ;

— le programme de test ;

— le programme du mode conservatif ;

— le programme de liaison avec le calculateur 34 ;

— les programmes de filtrage.

Le dispositif mémoire 35 du type RAM contient :

— les valeurs des tensions de prépositionnement fin ;

— les mémoires de travail.

L'interface lent 36 permet les modes d'initialisation et de contrôle. L'interface rapide 37 permet le mode normal de saut rapide et dispose d'une interruption prioritaire du microprocesseur 38. Le circuit de logique d'enchaînement 39 est programmable, en particulier en cas de filtrage numérique par le microprocesseur. Ce circuit 39 commande la remise à zéro du filtre 8, le blocage et le déblocage des échantillonneurs bloqueurs 40 et 41 reliés respectivement aux circuits sommateurs 17 et 18 correspondant aux prépositionnements fin et gros, et commande également le circuit de logique d'approximations sucessives 42. Un registre 43 est relié au circuit diviseur 2 par N.

A chaque commutation de fréquence, les différentes fonctions réalisées par le dispositif s'enchaînent de la façon suivante :

— le filtre passe-bas 8 est remis à zéro par la commande ;

— le dispositif mémoire 33 est mis en sélection pour fournir la tension de prépositionnement gros numérique $V_{NG}$ que le convertisseur numérique analogique 32 convertit analogiquement ;

— blocage de cette tension $V_{NG}$ dans l'échantillonneur bloqueur 41 ;

— le dispositif mémoire 35 est mis en lecture et sélection pour fournir la tension de prépositionnement fin $V_{NF}$ mémorisée au passage précédent sur la fréquence $f_N$ ;

— blocage de cette tension $V_{NF}$ fournie par le convertisseur numérique analogique 32 dans l'échantillonneur bloqueur 40 ;

— programmation de N dans le circuit diviseur 2 ;

— déblocage du filtre passe-bas 8 ;

— attente de stabilisation de la boucle de phase ;

— initialisation de la logique d'approximations successives 42 ;

— la logique d'approximations 42 successives délivre une tension V numérique, qui est convertie analogiquement dans le convertisseur 32 pour être comparée à la tension analogique $V'_{NF}$ dans le circuit 44 ; quand ces deux tensions analogiques V et $V'_{NF}$ sont égales, la logique s'arrête et la tension numérique alors obtenue est mémorisée dans la mémoire 35 qui est ensuite bloquée.

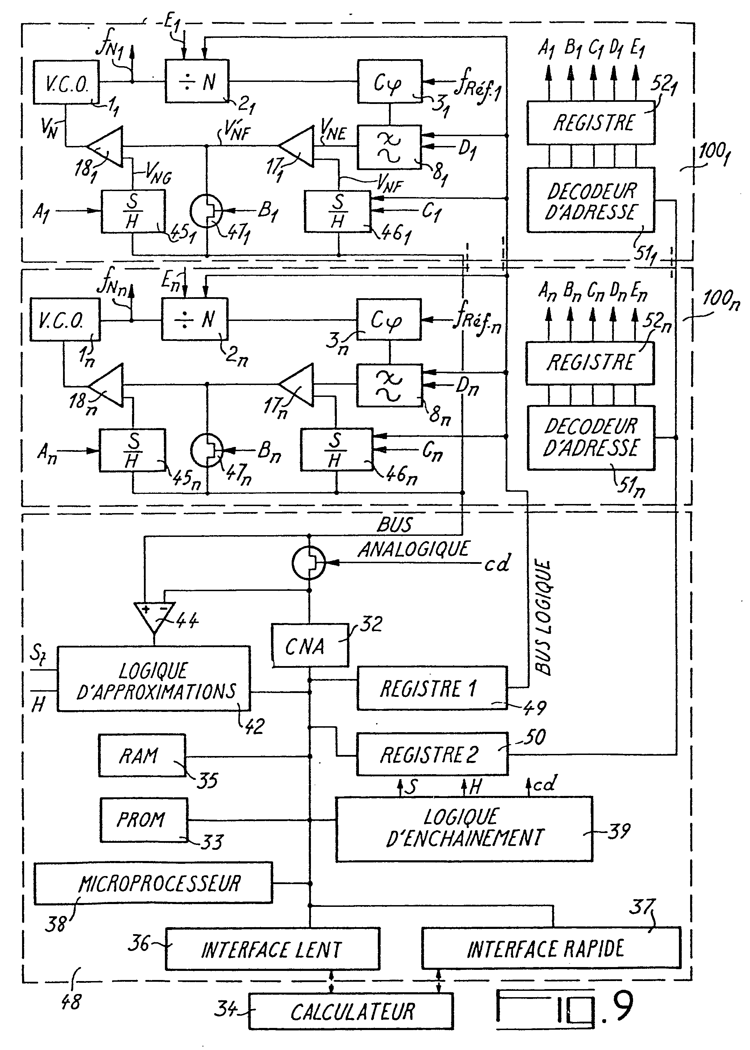

Un synthétiseur de fréquence à plusieurs boucles peut également être réalisé suivant l'invention, avec une partie intégrée en LS1, comme le montre la figure 9. Sur cette figure sont représentées la boucle $100_1$ et la boucle $100_n$ comprenant chacune les éléments $1_i$, $2_i$, $3_i$, $8_i$, $17_i$ et $18_i$ identiques à ceux des autres figures, ainsi que deux échantillonneurs-bloqueurs $45_i$ et $46_i$ — i variant de 1 à n — correspondant aux prépositionnements gros et fin et un dispositif de commutation $47_i$ réalisé par un transistor à effet de champ par exemple. La partie 48 réalisée en LSI est la même que pour la figure 8 et est commune à toutes les boucles. C'est pourquoi elle comporte deux registres 49 et 50, le premier étant relié à tous les circuits diviseurs 2 et le second étant relié à des décodeurs d'adresses $51_i$ — i variant de 1 à n — reliés eux-mêmes à des registres $52_i$ déclenchant les fonctions $A_i$, $B_i$, $C_i$, $D_i$ et $E_i$.

Les différentes étapes de la logique d'enchaînement du circuit sont les suivantes : le microprocesseur 38 commence par prépositionner chaque boucle $100_i$ en programmant les circuits diviseurs $2_i$ par l'intermédiaire de $E_i$ et en envoyant les tensions de prépositionnement gros $V_{NG}$ sur les échantillonneurs-bloqueurs $45_i$, contrôlés par $A_i$, et fin $V_{NF}$ sur les circuits $46_i$ échantillonneurs-bloqueurs contrôlés par $C_i$. La boucle de phase étant stabilisée, le microprocesseur va prélever les tensions d'erreur dans chaque boucle au niveau des dispositifs de commutation $47_i$, contrôlés par $B_i$, les convertir à l'aide des dispositifs 44, 42 et 32, comme cela a été fait dans la figure 8, et les mémoriser dans la mémoire RAM 35. Ce processus est le même que celui décrit précédemment, mais il est réalisé pour chaque boucle. On peut noter qu'une fréquence de référence $f_{ref_i}$ peut être donnée par la fréquence de sortie d'une autre boucle $F_{Nj}$.

### Revendications

1. Dispositif de prépositionnement de fréquence pour synthétiseur indirect à boucles de phase commutables asservissant sur une fréquence de référence stable un sous-multiple de la fréquence d'un oscillateur (1) commandé par une tension $V_N$ et comprenant au moins un générateur programmable de tension de prépositionnement (9), pour chaque fréquence commutée la tension de prépositionnement $V_{NP}$ programmée pour chaque boucle étant ajoutée à la tension d'erreur $V_{NE}$ établie dans la même boucle pour donner la tension de commande $V_N$ de l'oscillateur, caractérisé en ce qu'il comporte un dispositif (11) de mémorisation des valeurs de la tension de commande $V_N$ à chaque passage sur chaque fréquence $f_N$, ces valeurs étant utilisées aux passages suivants sur la même fréquence pour commander le générateur de prépositionnement (9) et le rendre ainsi auto-adaptatif.

2. Dispositif de prépositionnement suivant la revendication 1, comportant une seule boucle de phase commutable, caractérisé en ce que la tension de prépositionnement étant divisée en deux composantes $V_{NG}$ et $V_{NF}$ générées respectivement l'une par un générateur commutable de prépositionnement dit « grossier » (12) et l'autre par un générateur commutable de prépositionnement dit « fin » (13), il comporte un dispositif de mémorisation commutable (14) de la tension de prépositionnement fin $V_{NF}$.

3. Dispositif de prépositionnement selon la revendication 2, caractérisé en ce qu'il comporte un circuit (16) de mesure de la tension d'erreur résiduelle $V_{NE}$ délivrée par la boucle de phase lors de la commutation sur une fréquence $f_N$ donnée et un circuit commutable de logique de correction (15) recevant sur une entrée la tension d'erreur $V_{NE}$ et sur une autre entrée la valeur de la tension $V_{NF}$ mémorisée dans le circuit (14), lors du passage précédent sur la fréquence $f_N$, la sortie de ce circuit (15) délivrant la nouvelle valeur de la tension de prépositionnement fin $V_{NF}$ étant reliée d'une part au circuit mémoire (14) et d'autre part au générateur de prépositionnement fin (13).

4. Dispositif de prépositionnement selon la revendication 2, caractérisé en ce qu'il comprend un circuit sommateur (17) ajoutant la tension d'erreur $V_{NE}$ établie dans la boucle à la tension de prépositionnement fin $V_{NF}$ délivrée par le générateur (13) et délivrant une nouvelle tension $V'_{NF}$, un circuit de mesure (19) de la tension $V'_{NF}$ dont la sortie est reliée à l'entrée du circuit mémoire (20), et un circuit sommateur (18) ajoutant la tension $V'_{NF}$ à la tension $V_{NG}$ délivrée par le générateur de prépositionnement gros (12) pour donner la tension de commande $V_N$ de l'oscillateur (1).

5. Dispositif de prépositionnement selon la revendication 4, caractérisé en ce que le circuit de mesure de la tension $V'_{NF}$ est un filtre passe-bas (23), le circuit mémoire est une mémoire vive du type à accès aléatoire (24) et le générateur (13) est constitué par un échantillonneur-bloqueur (25).

6. Dispositif de prépositionnement selon la revendication 4, caractérisé en ce qu'il comprend un filtre passe-bas (26) mesurant la tension $V'_{NF}$ en sortie du circuit sommateur (17), un circuit de logique d'approximations sucessives (27) délivrant une tension numérique qui est convertie analogiquement dans un convertisseur (29) pour être comparée à la tension analogique $V'_{NF}$ dans un comparateur (28), une mémoire commutable à accès aléatoire (30) mémorisant la valeur de $V'_{NF}$ à chaque passage sur chaque fréquence $f_N$, au convertisseur (29) qui la transmet à un échantillonneur-bloqueur (31).

7. Dispositif de prépositionnement selon l'une des revendications 3 ou 4, caractérisé en ce que le générateur de prépositionnement gros (12) est constitué par une mémoire morte commutable (22) du type PROM reliée à un convertisseur numérique analogique (21).

8. Dispositif de prépositionnement selon l'une quelconque des revendications 1 à 7, caractérisé en ce qu'il est associé à un calculateur prélevant les valeurs de la tension de prépositionnement fin $V_{NF}$ afin de tester le synthétiseur.

**Claims**

1. A frequency presetting device for indirect synthetizer with switchable phase loops bringing under control of a stable reference frequency a sub-multiple of the frequency of an oscillator (1) controlled by a voltage $V_N$ and comprising at least one presetting voltage programmable generator (9) for each switched over frequency, the presetting voltage $V_{NP}$ programmed for each loop being added to the error voltage $V_{NE}$ established in the same loop in order to give the control voltage $V_N$ of the oscillator, characterized in that it comprises a storage device (11) of the values of the control voltage $V_N$ at each passage on each frequency $f_N$, these values being used at the following passages on the same frequency in order to control the presetting generator (19) and thus render it auto-adaptive.

2. A presetting device according to claim 1, comprising a single switchable phase loop, characterized in that the presetting voltage being divided into two components $V_{NG}$ and $V_{NF}$ generated respectively, one by a switchable presetting generator called « rough » (12) and the other by a switchable presetting generator called « fine » (13), it comprises a switchable storage device (14) of the fine presetting voltage $V_{NF}$.

3. A presetting device according to claim 2, characterized in that it comprises a circuit (16) for measuring the residual error voltage $V_{NE}$ supplied by the phase loop during switch over on a given frequency $f_N$ and switchable correction logic circuit (15) receiving on one input the error voltage $V_{NE}$ and on another input the voltage blue $V_{NF}$ stored in the circuit (14), during the previous passage on frequency $f_N$, the output of this circuit (15) supplying the new value of the fine presetting voltage $V_{NF}$ being connected on the one hand, to the memory circuit (14) and, on the other hand, to the fine presetting generator (13).

4. A presetting device according to claim 2, characterized in that it comprises a summator circuit (17) adding the error voltage $V_{NE}$ established in the fine presetting voltage $V_{NF}$ delivered by the generator (13) and supplying an new voltage $V'_{NF}$, a measurement circuit (19) of the voltage $V'_{NF}$ the output of which is connected to the input of the memory circuit (20) and a summator circuit (18) adding the voltage $V'_{NF}$ to the voltage $V_{NG}$ delivered by the rough presetting generator (12) in order to give the control voltage $V_N$ of the oscillator (1).

5. A presetting device according to claim 4, characterized in that the measurement circuit of the voltage $V'_{NF}$ is a low-pass filter (23), the memory circuit is a rapid memory (24) of the random access type and the generator (13) is constituted by a blocker-sampler (25).

6. A presetting device according to claim 4, characterized in that it comprises a low-pass filter (26) measuring the voltage $V'_{NF}$ in the output of the summator circuit (17), a logic circuit of successive approximations (27) delivering a digital voltage that is analogously converted in a converter (29) to be compared to the analogous voltage $V'_{NF}$ in a comparator (28), a switchable random access memory (30) memorizing the value of $V'_{NF}$ at each passage on each frequency $f_N$, at the converter (29) that transmits it to the blocker-sampler (31).

7. A presetting device according to either of claims 3 or 4, characterized in that the rough presetting generator (12) is constituted by a switchable read only memory (22) of the PROM type connected to an analogous digital converter (21).

8. A presetting device according to any one of claims 1 to 7, characterized in that it is associated to a calculator collecting the values of the fine presetting voltage $V_{NF}$ in order to test the synthetizer.

**Ansprüche**

1. Vorrichtung zur Frequenzvorregelung für einen Indirektsynthetisierer mit umschaltbaren Phasenschleifen, der auf einer konstanten Bezugsfrequenz eine Bruchteil der Frequenz einen durch eine Spannung $V_N$ gesteuerten Oszillators (1) steuert, welcher wenigstens einen programmierbaren Vorregelungsspannungserzeuger (9) umfasst, wobei für jede umgeschaltete Frequenz die für jede Schleife programmierte Vorregelungsspannung $V_{NP}$ der in der gleichen Schleife erzielten Fehlerspannung $V_{NE}$ beigefügt wird, um die Steuerspannung $V_N$ des Oszillators zu ergeben, dadurch gekennzeichnet, dass sie eine Speichervorrichtung (11) zum Speichern der Werte der Steuerspannung $V_N$ beim Übergang auf jede Frequenz $f_N$ umfasst, wobei diese Werte bei den nachfolgenden Übergängen auf die gleiche Frequenz verwendet werden, um den Vorregelungserzeuger (9) zu steuern und es demselben zu ermöglichen, sich automatisch anzupassen.

2. Vorregelungsvorrichtung nach Anspruch 1, mit einer einzigen umschaltbaren Phasenschleife, dadurch gekennzeichnet, dass die Vorregelungsspannung in zwei Komponenten $V_{NG}$ und $V_{NF}$ unterteilt ist, deren eine von einem umschaltbaren sog. « Grob »-Vorregelungserzeuger (12) und die andere von einem umschaltbaren sog. « Fein »-Vorregelungserzeuger (13) erzeugt wird, und dass die Vorregelungsvorrichtung eine umschaltbare Speichervorrichtung (14) zum Speichern der Feinvorregelungsspannung $V_{NF}$ umfasst.

3. Vorregelungsvorrichtung nach Anspruch 2, dadurch gekennzeichnet, sie dass sie einen Messkreis (16) zum Messen der Restfehlerspannung $V_{NE}$ umfasst, die beim Umschalten auf eine gegebene Frequenz $f_N$ von der Phasenschleife geliefert wird, sowie einen umschaltbaren Korrekturlogikkreis (15), an dessen einen Eingang die Fehlerspannung $V_{NE}$ und an dessen anderen Eingang der im Kreis (14) beim vorhergehenden Überbang auf die Frequenz $f_N$ gespeicherte Wert der Spannung $V_{NF}$ angelegt ist, während der den neuen Wert der Feinvorregelungsspannung $V_{NF}$ liefernde Ausgang dieses Kreises (15) einerseits an den Speicherkreis (14) und andererseits an den Feinvorregelungserzeuger (13) angeschlossen ist.

4. Vorregelungsvorrichtung nach Anspruch 2, dadurch gekennzeichnet, dass er einen Summierkreis (17) umfasst, der die in der Schleife auftretende Fehlerspannung $V_{NE}$ der vom Erzeuger (13) gelieferten Feinvorregelungsspannung $V_{NF}$ beifügt und eine neue Spannung $V'_{NF}$ liefert, sowie einen Messkreis (19) zum Messen der Spannung $V'_{NF}$, dessen Ausgang mit dem Eingang des Speicherkreises (20) verbunden ist, und ferner einen Summierkreis (18), der die Spannung $V'_{NF}$ der vom Grobvorregelungserzeuger (12) erzeugten Spannung $V_{NG}$ beifügt, um die Steuerspannung $V_N$ des Oszillators (1) zu liefern.

5. Vorregelungsvorrichtung nach Anspruch 4, dadurch gekennzeichnet, dass der Messkreis für die Spannung $V'_{NF}$ durch ein Tiefpassfilter (23), der Speicherkreis durch einen Aktivspeicher mit unbestimmten Zugang (24), und der Erzeuger (13) durch einen Blockier-Bemusterer (25) gebildet wird.

6. Vorregelungsvorrichtung nach Anspruch 4, dadurch gekennzeichnet, dass sie ein die Spannung $V'_{NF}$ am Ausgang des Summierkreises (17) messenden Tiefpassfilter (26) aufweist, ferner einen Logikkreis (27) für aufeinanderfolgende Annäherungen, der eine numerische Spannung liefert, welche in einem Wandler (29) analog gewandelt wird, um in einem Vergleicher (28) mit der Analogspannung $V'_{NF}$ verglichen zu werden, sowie einen umschaltbaren Speicher (30) mit unbestimmtem Zugang (30), der den Wert von $V'_{NF}$ bei jedem Übergang auf jede Frequenz $f_N$ speichert, und zwar am Wandler (29), der sie an den Blockier-Bemusterer (31) überträgt.

7. Vorregelungsvorrichtung nach einem der Ansprüche 3 oder 4, dadurch gekennzeichnet, dass der Grobvorregelungserzeuger (12) durch einen an einen numerisch-analogen Wandler (21) angeschlossen umschaltbaren Totspeicher (22) des Typs PROM gebildet wird.

8. Vorregelungsvorrichtung nach einem der Ansprüche 1 bis 7, dadurch gekennzeichnet, dass er einem die Werte der Feinvorregelungsspannung $V_{NF}$ abnehmenden Rechner beigeordnet ist, um den Synthetisierer zu prüfen.

# FIG. 1

V.C.O. — 1

$f_N$

$\div N$ — 2

$\dfrac{f_N}{N}$

$C\varphi$ — 3

$f_{Réf.}$

$V_N$

5

$x \atop \sim$ — 4

# FIG. 2

V.C.O. — 1

$f_N$

$\div N$ — 2

$\dfrac{f_N}{N}$

$C\varphi$ — 3

DISCRIMINATEUR — 6

$f_{Réf.}$

10

$+$  $+$

$V_{NP}$

$+$  $+$ — 7

GENERATEUR PREPOSITION-NEMENT — 9

$V_{NE}$

$x \atop \sim$ — 8

COMMANDE COMMUTATION DE FREQUENCE — 100

$$\Box \Box . 3$$

V.C.O.

$\div N$

$f_N$

$f_{R\acute{e}f.}$

1

2

3

$V_N$

$V_{NE}$

8

10

$V_{NP}$

MEMOIRE

GENERATEUR
PREPOSITIONNEMENT

11

9

COMMUTATION DE FREQUENCE 100

$$\Box \Box . 4$$

V.C.O.

$\div N$

$f_N$

$\dfrac{f_N}{N}$

$f_{R\acute{e}f.}$

1

2

3

10

$V_{NE}$

RAZ

$V_{NF}$

13

14

8

$V_{NG}$

PREPOSITION-
NEMENT FIN

MEMOIRE

MESURE

16

12

PREPOSITION-
NEMENT GROS

LOGIQUE DE
CORRECTION

15

100 COMMUTATION DE FREQUENCE

FIG.5

FIG. 6

$$\boxed{\text{FI}\square\text{.}7}$$

FIG. 8

0 041 882

IO.9